**Europäisches Patentamt**

**European Patent Office**

**Office européen des brevets**

(11) Veröffentlichungsnummer : **0 120 288**
**B1**

(12) **EUROPÄISCHE PATENTSCHRIFT**

(45) Veröffentlichungstag der Patentschrift :
**09.09.87**

(51) Int. Cl.⁴ : **H 03 K 17/04**, H 03 K 17/10

(21) Anmeldenummer : **84101810.4**

(22) Anmeldetag : **21.02.84**

(54) **Transistorleistungsschalter.**

(30) Priorität : **23.02.83 DE 3306344**

(43) Veröffentlichungstag der Anmeldung :
**03.10.84 Patentblatt 84/40**

(45) Bekanntmachung des Hinweises auf die Patenterteilung : **09.09.87 Patentblatt 87/37**

(84) Benannte Vertragsstaaten :
**AT BE CH DE FR GB IT LI NL SE**

(56) Entgegenhaltungen :
**GB-A- 2 053 606**
**Markt und Technik, Nr. 28, Seiten 66-68**
**ELEKTRONIK, Nr. 23, 1981, B. TAYLOR "HEXFETs in hochsperrenden Schaltungen bei hohem Wirkungsgrad", Seiten 93-96**
**ELEKTRIE, Band 36, Nr. 7, 1982, F. FISCHER et al., "Leistungs-MOSFETs in der Energieelektronik", Seiten 366-370**
**ELECTRONIC ENGINEERING, November 1981, B. TAYLOR "High efficiency power switching with cascoded HEXFETs and bipolars", Seiten 61-68**

(73) Patentinhaber : **Siemens Aktiengesellschaft Berlin und München**
**Wittelsbacherplatz 2**
**D-8000 München 2 (DE)**

(72) Erfinder : **Klauck, Bernd, Dipl.-Ing.**
**St. Cajetanstrasse 7**
**D-8000 München 80 (DE)**

## Beschreibung

Die Erfindung betrifft einen Leistungsschalter, bestehend aus einer Kaskadenschaltung eines bipolaren Transistors und eines MOS-Feldeffekttransistors und aus einem Transformator, dessen Primärwicklung in der gesteuerten Strecke des bipolaren Transistors liegt, und dessen Sekundärwicklung als Rückkopplung parallel mit dem Steuereingang des bipolaren Transistors und mit einem Kondensator verbunden ist.

Zum Schalten von hohen Arbeitsspannungen bei gutem Wirkungsgrad ist eine Transformatorgekoppelte Kaskadenschaltung aus einem bipolaren Transistor und einem MOS-Feldeffekttransistor (MOS-FET)aus der Zeitschrift Markt und Technik, Nr. 28, vom 3.12.1982, Seite 66 bis 68, bekannt. Zur Rückkopplung sind die gleichpoligen Enden der Wicklungen auf der Primärseite mit dem Kollektor eines bipolaren Transistors und auf der Sekundärseite mit einem Bezugspotentialleiter verbunden, während das zweite Ende der Sekundärwicklung über eine Gleichrichterdiode an die Basis des bipolaren Transistors geführt ist. Für manche Einsatzfälle, beispielsweise zum Ansteuern einer Horizontalendstufe eines Datensichtgerätes, sind auch bei kurzen Einschaltzeiten die Speicherund Abfallzeiten zu lang.

Der Erfindung lag daher die Aufgabe zugrunde, einen Leistungsschalter der oben genannten Art anzugeben, mit welchem die Schaltzeiten auch bei hohen Schaltfrequenzen verkürzt sind.

Diese Aufgabe wird dadurch gelöst, daß der bipolare Transistor derart in den Rückkopplungskreis geschaltet ist, daß die Wicklungsanschlüsse gleicher Polarität der Sekundär- bzw. primärwicklung mit dem Steuereingang bzw. mit einem der anderen Anschlüsse des bipolaren Transistors verbunden sind. Auf diese Weise kann eine Verkürzung der Speicherzeit auf etwa 1/10 der bekannten Schaltung erreicht werden. Im folgenden wird die Erfindung anhand eines bevorzugten Ausführungsbeispiels weiter beschrieben.

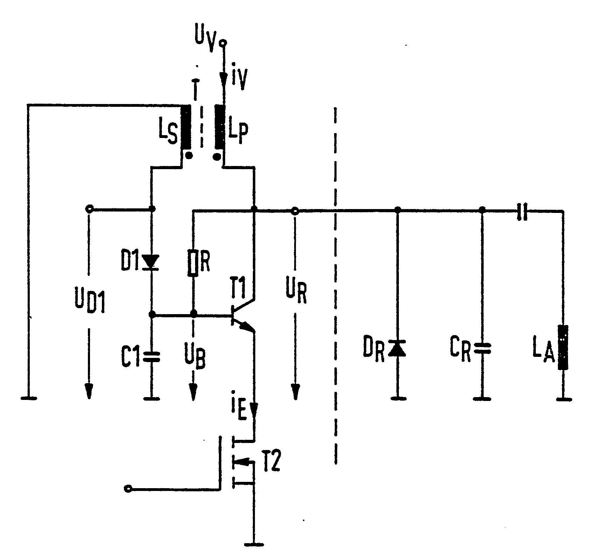

Die Figur zeigt ein Anwendungsbeispiel des erfindungsgemäßen Leistungsschalters zur Ansteuerung einer Horizontalendstufe eines Datensichtgerätes.

Die Schaltung besteht aus einer Kaskadenschaltung eines mit einem Transformator T rückgekoppelten bipolaren Transistors T1 und eines Leistungs-MOS-FET T2 in Basisschaltung, wobei der Emitter-und Drainanschluß zusammengeschaltet sind. Die Primärwicklung $L_p$ des Transformators T liegt am Kollektoreingang in der gesteuerten Strecke des bipolaren Transistors T1. Die Sekundärwicklung $L_s$ ist über eine Diode D1 parallel mit dem Steuereingang des bipolaren Transistors T1 und über einen Kondensator C1 mit einem Bezugspotential verbunden. Am zweiten Ende der Primärwicklung $L_p$ liegt eine Betriebsspannung $U_v$ an. Das zweite Ende der Sekundärwicklung $L_s$ ist auf das Bezugspotential gelegt.

Die Wicklungsanschlüsse des Transformators T sind so geschaltet, daß die Anschlüsse gleicher Polarität mit dem Kollektoreingang bzw. dem Basiseingang des bipolaren Transistors T1 verbunden sind.

Der Ablenkkreis der Horizontalendstufe besteht aus einer parallelschaltung einer weiteren Diode $D_R$ eines weiteren Kondensators $C_R$ und aus einer hinter einem Koppelkondensator geschalteten Ablenkspule $L_A$. Diese Parallelschaltung liegt am Verbindungspunkt der beiden Transistoren.

Die Funktion der Erfindung wird aus der folgenden Beschreibung deutlich : Ein vom Ablenkkreis erzeugter Zeilenrückschlagimpuls der Spannung $U_R$, der beispielsweise sinusförmig ist, lädt über den Transformator T den Kondensator C1 auf die Spannung $U_B$ auf. Die Größe der Kondensatorspannung $U_B$ ist abhängig von der Höhe des Zeilenrückschlagimpulses und vom Übersetzungsverhältnis des Transformators T. Der Emitter des bipolaren Transistors T1 liegt offen, da der MOS-FET T2 gesperrt ist. Unterschreitet die abfallende Flanke des Zeilenrückschlag impulses die Spannung $U_B$, so entlädt sich der Kondenstor C1 über die BasisKollektorstrecke des bipolaren Transistors TI und macht diese für eine Zeitdauer leitend, die von der Größe des Kondensators C1 abhängt. Dabei überschwemmt ein Ladungsstoß die Basis-Kollektor-Strecke mit Ladungsträgern und bringt sie stationär in den leitenden Zustand, da die Ladung nicht über den offenliegenden Emitter abfließen kann.

Nun wird der MOS-FET T2 durchgeschaltet. Durch die Ladungsträger in der Basis-Kollektorstrecke ist der bipolare Transistor T1 leitend, obwohl der Steuereingang gesperrt ist, weil die Spannung $U_{D1}$ am Eingang der Diode D1 aufgrund des Wicklungssinnes der Sekundärspule $L_s$ negativ ist und der Kondensator C1 über die Basis-Kollektorstrecke von T1 entladen ist.

Das Ausschalten erfolgt durch eine Unterbrechung des Emitterstroms $I_E$ mittels des MOS-FET T2. Da in der Schaltphase kein Basisstrom geflossen ist, wird dabei nur die BasisKollektorstrecke des bipolaren Transistors T1 ausgeräumt. Der entstehende Rückschlagimpuls $U_R$ lädt den Kondensator C1 auf $U_B$ und der Anfangszustand ist wieder hergestellt.

Der Widerstand R dient zum einmaligen Aufladen des Kondensators C1 auf die Betriebsspannung $U_v$, damit die Schaltung anlaufen kann.

## Patentanspruch

Leistungsschalter, bestehend aus einer Kaskadenschaltung eines bipolaren Transistors und eines MOS-Feldeffekttransistors und aus einem Transformator, dessen Primärwicklung in der gesteuerten Strecke des bipolaren Transistors liegt, und dessen Sekundärwicklung als Rückkopplung parallel mit dem Steuereingang des bipolaren Transistors und mit einem Kondensator verbunden ist, dadurch gekennzeichnet, daß der bipolare Transistor (T1) derart in den Rückkopplungskreis geschaltet ist, daß die Wicklungsanschlüsse gleicher Polarität der Sekundär- bzw. Primärwicklung ($L_s$, $L_p$) mit dem Steuereingang bzw. mit einem der anderen Anschlüsse des bipolaren Transistors (T1) verbunden sind.

## Claim

A power switch consisting of a cascade having a bipolar transistor, an MOS field-effect transistor and a transformer whose primary winding is arranged in the controlled section of the bi-polar transistor and whose secondary winding as a feedback loop is connected to the control input of the bipolar transistor and to a capacitor, characterised in that the bipolar transistor (T1) is arranged in the feedback loop such that a secondary winding's ($L_s$) terminal with a given polarity is connected to the control input of the bipolar transistor (T1) and the primary winding's ($L_p$) terminal with the same polarity is connected to one of the other terminals of the bipolar transistor (T1).

## Revendication

Interrupteur de puissance, constitué par un montage en cascade d'un transistor bipolaire et d'un transistor à effet de champ MOS et par un transformateur dont l'enroulement primaire est monté dans la voie commandée du transistor bipolaire et dont l'enroulement secondaire est raccordé en parallèle, en tant que circuit de réaction, à l'entrée de commande du transistor bipolaire et à un condensateur, caractérisé par le fait que le transistor bipolaire (T1) est monté dans le circuit de réaction de telle sorte que les bornes de même polarité de l'enroulement secondaire ou de l'enroulement primaire ($L_s$, $L_p$) sont reliées à la borne de commande ou à l'une des autres bornes du transistor bipolaire (T1).